# EUROPÄISCHE PATENTANMELDUNG

(11) **EP 0 863 540 A1**
(43) Veröffentlichungstag der Anmeldung: **09.09.1998**
(21) Anmeldenummer: 98104008.2
(22) Anmeldetag: 06.03.1998
(51) Int. Cl.: H01L 21/306

(54) **Verfahren zur Behandlung einer polierten Halbleiterscheibe gleich nach Abschluss einer Politur der Halbleiterscheibe**

(30) Priorität: 06.03.1997 DE 19709217
(71) Anmelder: Wacker Siltronic Gesellschaft für Halbleitermaterialien Aktiengesellschaft, 84489 Burghausen (DE)
(72) Erfinder: Hennhöfer, Heinrich, 84503 Altötting (DE); Buschhardt, Thomas, 84489 Burghausen (DE); Mangs, Franz, 84569 Tittmoning (DE); Wensauer, Gerlinde, 84503 Altötting (DE)

(57) **Zusammenfassung**

Gegenstand der Erfindung ist ein Verfahren zur Behandlung einer polierten Halbleiterscheibe gleich nach Abschluß einer Politur der Halbleiterscheibe. Die Halbleiterscheibe wird mit einem wässerigen Behandlungsmittel in Kontakt gebracht und ihre polierte Oberfläche wird durch Einwirkung des Behandlungsmittels oxidiert.

## Beschreibung

Die Erfindung betrifft ein Verfahren zur Behandlung einer polierten Halbleiterscheibe gleich nach Abschluß einer Politur der Halbleiterscheibe. Die Politur der Halbleiterscheibe stellt den letzten, die Formgebung der Halbleiterscheibe maßgeblich beeinflussenden Schritt bei der Herstellung der Halbleiterscheibe dar. Ziel der Politur ist es, auf wenigstens einer der beiden Seiten der Halbleiterscheibe eine möglichst ebene, glatte und defektfreie Oberfläche zu schaffen. Eine solche Oberfläche ist zwingend notwendig, um funktionierende elektronische Strukturen in hoher Dichte auf der Halbleiterscheibe unterbringen zu können. Bestimmte Defekte auf der Oberfläche der Halbleiterscheibe, die später zum Ausfall eines elektronischen Bauelements fuhren können, können an einem charakteristischen Lichtstreuverhalten erkannt und als sogenannte LPD's ("light point defects") bezüglich Größe und Anzahl angegeben werden.

Zur Politur einer Halbleiterscheibe werden üblicherweise Einseiten- und Doppelseiten-Polierverfahren eingesetzt. Bei der Einseitenpolitur ("single side polishing", SSP) wird nach Montage der Rückseite der Halbleiterscheibe auf einen geeigneten Träger nur die Vorderseite mit einem auf einen Polierteller gespannten Poliertuch poliert. Bei der Montage wird zwischen der Rückseite und dem Träger eine form- und kraftschlüssige Verbindung, beispielsweise durch Adhäsion, Kleben, Kitten oder Vakuumanwendung, hergestellt. Einseiten-Polierverfahren und -Vorrichtungen sind für die Einzelscheiben-Behandlung ("single wafer polishing") oder für die Behandlung von Gruppen von Scheiben ("batch polishing") üblich. Bei der Doppelseitenpolitur ("double side polishing", DSP) werden Vorderseite und Rückseite gleichzeitig poliert, indem mehrere Halbleiterscheiben zwischen zwei mit Poliertüchern bespannten, oberen und unteren Poliertellern geführt werden. Dabei liegen die Halbleiterscheiben in dünnen Führungskäfigen ("wafer carrier"), die als Läuferscheiben bezeichnet werden und in ähnlicher Form auch beim Läppen von Halbleiterscheiben verwendet werden.

Die polierte Oberfläche einer Halbleiterscheibe hat hydrophobe Eigenschaften. Sie ist sehr empfindlich gegenüber einem unkontrollierten, chemischen Angriff durch ein Ätzmittel und sie begünstigt die Ablagerung von Partikeln. Beides kann zu einem relativ raschen Anstieg der Anzahl von LPD's führen. Ein solcher Anstieg kann vermieden werden, indem für eine möglichst partikelfreie Umgebung gesorgt wird und ein unkontrollierter, chemischer Angriff durch Poliermittelreste unterbunden wird, indem die Halbleiterscheibe gleich nach der Politur in ein Spül- oder Reinigungsbad überführt wird.

Umgekehrt ist ein zeitlicher Anstieg der Anzahl von LPD's selbst dann noch zu beobachten, wenn die Halbleiterscheibe gleich nach der Politur in deionisiertem Wasser gelagert und erst anschließend einer üblichen Reinigungsprozedur unterworfen wird. Bei einer Massenproduktion von Halbleiterscheiben sind jedoch Wartezeiten zwischen der Politur und der Reinigung einer polierten Halbleiterscheibe unter technischen und wirtschaftlichen Gesichtspunkten oft wünschenswert. Würde jede Halbleiterscheibe sofort nach der Politur gereinigt werden müssen, wäre eine Einzelscheiben-Behandlung notwendig, die insbesondere nach einem "batch-polishing" nur mit großem technischen Aufwand realisiert werden kann und entsprechend teuer ist.

Die vorliegende Erfindung löst die Aufgabe, einer starken Zunahme der Anzahl von LPD's entgegenzuwirken, wenn eine polierte Halbleiterscheibe nicht gleich nach der Politur gereinigt, sondern zuvor gelagert wird.

Gegenstand der Erfindung ist ein Verfahren zur Behandlung einer polierten Halbleiterscheibe gleich nach Abschluß einer Politur der Halbleiterscheibe, das dadurch gekennzeichnet ist, daß die Halbleiterscheibe mit einem wässerigen Behandlungsmittel in Kontakt gebracht wird und ihre polierte Oberfläche durch Einwirkung des Behandlungsmittels oxidiert wird.

Danach ist die polierte Oberfläche der Halbleiterscheibe mit einem dünnen Oxidfilm überzogen und hat hydrophile Eigenschaften. Die Halbleiterscheibe wird dadurch unempfindlicher gegenüber Poliermittelresten und Partikeln. Sie kann im Anschluß an die oxidierende Behandlung gelagert und erst später in üblicher Weise gereinigt werden, ohne daß während der Lagerungszeit ein starker Anstieg der Anzahl von LPD's zu befürchten ist.

Als Behandlungsmittel wird eine wässerige, oxidierende und alkalisch reagierende Lösung vorgeschlagen. Durch die Einwirkung einer solchen Lösung entsteht ein dünner, passivierender Oxidfilm auf der polierten Oberfläche der Halbleiterscheibe. Es ist bevorzugt, daß das wässerige Behandlungsmittel Wasserstoff-Peroxid (H₂O₂) als Oxidationsmittel und eine alkalisch reagierende Komponente enthält. Diese Komponente wird vorzugsweise aus einer Gruppe ausgewählt, die die Verbindungen Tetramethylammoniumhydroxid, Ammoniumhydroxid, Kaliumhydroxid, Natriumhydroxid, Kaliumcarbonat und Mischungen dieser Verbindungen umfaßt. Besonders bevorzugt ist es, ein Behandlungsmittel zu verwenden, das das Oxidationsmittel in einer Konzentration von 0,02 bis 3,0 Vol.-% und die alkalisch reagierende Komponente in einer Konzentration von 0,01 bis 2,0 Gew.-% enthält und eine Temperatur von 18 bis 65 °C aufweist.

Es wurde darüber hinaus festgestellt, daß auch eine gewisse Passivierung der polierten Oberfläche der Halbleiterscheibe eintritt, wenn die Halbleiterscheibe mit einem tensidhaltigen Reinigungsmittel oder Medium behandelt wird.

Die Halbleiterscheibe kann mit dem Behandlungsmittel auf verschiedene Weise in Kontakt gebracht werden. Dies kann geschehen, solange die Halbleiterscheibe noch auf dem Polierteller liegt. Andererseits kann die Halbleiterscheibe zuvor auch vom Polierteller genommen und auf eine andere Unterlage oder in eine Halterung umgesetzt werden. Die oxidierende Behandlung findet dementsprechend vorzugsweise in der Poliermaschine oder in einer daran angeschlossenen Entladestation statt. Sie kann ausgeführt werden, indem die polierte Oberfläche der Halbleiterscheibe mit einem Tuch, das mit dem Behandlungsmittel befeuchtet ist, in Kontakt gebracht wird, oder indem die polierte Oberfläche mit dem Behandlungsmittel besprüht wird. Die Halbleiterscheibe kann auch in ein Bad des Behandlungsmittels getaucht werden. Eine Behandlung mit einem angefeuchteten Tuch erfolgt vorzugsweise in gleicher Weise wie eine Politur, wobei an die Stelle des Poliertuches das mit dem Behandlungsmittel befeuchtete Tuch tritt und auf ein Poliermittel verzichtet wird.

Es ist zweckmäßig, das Behandlungsmittel nach der oxidierenden Behandlung von der Halbleiterscheibe zu spülen, vorzugsweise mit deionisiertem Wasser. Die Halbleiterscheibe ist gegen einen unerwünschen Angriff von Poliermittel ausreichend geschützt und kann bis zur üblichen Reinigung gelagert werden, vorzugsweise ebenfalls in deionisiertem Wasser. Die Lagerungszeit beträgt vorzugsweise 15 bis 180 min, besonders bevorzugt 15 bis 30 min. Anschließend wird die Halbleiterscheibe gereinigt. Es ist bevorzugt, die Reinigung mit einer Behandlung der Halbleiterscheibe mit verdünnter Flüßsäure zu beginnen, wodurch der Oxidfilm entfernt wird. Die weitere Reinigung der Halbleiterscheibe kann dann beispielsweise die bekannte RCA-Reinigung oder eine Variante von dieser umfassen.

Die Erfindung wurde an Siliciumscheiben getestet. Dazu wurden Testscheiben gleich nach einer Standardpolitur erfindungsgemäß behandelt und anschließend in deionisiertem Wasser gelagert. Danach wurden die Scheiben einer abschließenden Reinigung unterzogen, getrocknet und mit einem handelsüblichen Analysengerät auf LPD's untersucht. Weitere Siliciumscheiben wurden als Vergleichsscheiben in gleicher Weise poliert, in deionisiertem Wasser gelagert und gereinigt. Eine erfindungsgemäße Behandlung gleich nach der Politur fand bei diesen Scheiben nicht statt.

In der nachfolgenden Tabelle sind die Ergebnisse der LPD-Bestimmung aufgelistet. Angegeben ist die relative Anzahl gefundener LPD's > 0,12 µm. Bezugsgröße ist die bei den Vergleichsscheiben vom Typ I gefundene und auf 100 % normierte Anzahl von LPD's.

**Tabelle:**

| Scheibenart | Dauer der Lagerung | LPD's [%] |
|---|---|---|
| Testscheiben I | keine Lagerung | 136 |
| Vergleichsscheiben I | keine Lagerung | 100 |
| Testscheiben II | 3 Stunden | 96 |
| Vergleichsscheiben II | 3 Stunden | 400 |
| Testscheiben III | 5 Stunden | 727 |
| Vergleichsscheiben III | 5 Stunden | 1.878 |

## Patentansprüche

1. Verfahren zur Behandlung einer polierten Halbleiterscheibe gleich nach Abschluß einer Politur der Halbleiterscheibe, dadurch gekennzeichnet, daß die Halbleiterscheibe mit einem wässerigen Behandlungsmittel in Kontakt gebracht wird und ihre polierte Oberfläche durch Einwirkung des Behandlungsmittels oxidiert wird.

2. Verfahren nach Anspruch 1, dadurch gekennzeichnet, daß die Halbleiterscheibe mit einem Behandlungsmittel in Kontakt gebracht wird, das ein Oxidationsmittel und eine alkalisch reagierende Komponente enthält.

3. Verfahren nach Anspruche 1 oder Anspruch 2, dadurch gekennzeichnet, daß das Behandlungsmittel mit der Halbleiterscheibe auf eine Weise in Kontakt gebracht wird, die das Bespruhen der Halbleiterscheibe mit dem Behandlungsmittel, das Eintauchen der Halbleiterscheibe in das Behandlungsmittel und das Aufbringen des Behandlungsmittels auf die polierte Oberfläche der Halbleiterscheibe mittels eines mit dem Behandlungsmittel angefeuchteten Tuches umfaßt.

4. Verfahren nach einem der Ansprüche 1 bis 3, dadurch gekennzeichnet, daß die Halbleiterscheibe mit dem Behandlungsmittel in einer Poliermaschine oder in der Entladestation einer Poliermaschine in Kontakt gebracht wird.

5. Verfahren nach einem der Ansprüche 1 bis 4, dadurch gekennzeichnet, daß die Halbleiterscheibe nach Einwirkung des Behandlungsmittels in deionisiertem Wasser gelagert wird.
